(19)

**Europäisches Patentamt**

**European Patent Office**

**Office européen des brevets**

(11) **EP 4 293 848 A1**

(12) **EUROPEAN PATENT APPLICATION**

(43) Date of publication:
**20.12.2023 Bulletin 2023/51**

(21) Application number: **23176302.0**

(22) Date of filing: **31.05.2023**

(51) International Patent Classification (IPC):
**H02H 3/28** *(2006.01)* **H02H 7/26** *(2006.01)*
**H02H 3/52** *(2006.01)*

(52) Cooperative Patent Classification (CPC):
**H02H 7/268; H02H 3/28;** H02H 3/52

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.06.2022 US 202217843048**

(71) Applicant: **Honeywell Limited
Mississauga, ON L5L 3S6 (CA)**

(72) Inventors:
• **CHENG, Louis
Charlotte 28202 (US)**
• **FULLER, Randy
Charlotte 28202 (US)**
• **XU, Yonghui
Charlotte 28202 (US)**

(74) Representative: **LKGlobal UK Ltd.
Cambridge House
Henry Street
Bath BA1 1BT (GB)**

(54) **FAULT DETECTION IN A POWER DISTRIBUTION SYSTEM PROVIDING HIGH VOLTAGE DIRECT CURRENT THROUGH MULTIPLE CHANNELS WITH A FLOATING GROUND**

(57) A method for isolating an electrical fault in a floating High Voltage direct current (DC) system is provided. The method includes receiving a measurement of an output voltage of a High Voltage DC bus and receiving a measurement of a load current for each of a plurality of channels coupled to the High Voltage DC bus. The method also includes, when the output voltage is determined to be out of balance, comparing the measurement of the load current of each of the plurality of channels in the frequency domain, and, flagging one channel of the plurality of channels as a faulty channel based on the comparing the measurement of the load currents in the frequency domain.

FIG. 1

**Description**

**BACKGROUND**

Many modern electronic systems are powered by systems that receive and distribute high voltage direct current (DC) power from a high voltage power source. Such systems are used, for example, to provide power to various electronic components on an aircraft or other vehicle. In such systems, power from the power source is delivered over a distribution system to various loads through a number of branches or channels. As is common practice, such systems typically provide a ground return path by connecting a common point on the power source to physical ground, e.g., the chassis of an aircraft or other vehicle.

Unfortunately, when operating a power system, a fault may occur in one of the branches or channels of the distribution system. The signature indication of a fault condition is the existence of a high direct current (DC) signal in the branch or channel of the power system with the fault. The high current signal can be detected by monitoring the current in each branch or channel of the power distribution system. Thus, in existing systems, it is easy to identify the faulty circuit.

Although the fault can be easily detected, the fault can cause damage to the power distribution system through the excessive current or by an electric arc. Also, the fault can cause excessive heat in the distribution system which may result in a fire or an explosion. Other apparatus and circuits coupled to the power distribution system can also be damaged by the fault. In some instances, prior art systems are taken off-line completely to be able to extinguish an electric arc. As the voltage and power levels used in modern electronic systems increase, the fault current becomes increasingly large and more damaging. In aircraft applications, critical systems such as electrical propulsion systems receive power from these distribution systems. These systems must be kept on-line and protected from the potential damage caused by faults to avoid catastrophe.

In some high voltage DC power systems, the DC ground is removed so that filtering components for electromagnetic filtering can be optimized. As an additional benefit, the fault currents are substantially reduced, thus minimizing some of the risks discussed above. Thus a high voltage DC power system with a floating ground may help reduce some of the problems identified above.

Unfortunately, this reduction in fault current by floating the ground of the power distribution system is not without its drawbacks. By floating the ground, it is difficult to determine which branch of the distribution system has the fault condition because the signature high fault current is gone. If the fault cannot be located, then it cannot be isolated. This can lead to additional safety issues for the electronic system of the same or similar magnitude as with the grounded power distribution systems.

Thus, there is a need in the art for fault detection and isolation in power distribution systems providing high voltage DC power through multiple channels with a floating ground.

**SUMMARY**

In one embodiment, a method for isolating an electrical fault in a floating High Voltage direct current (DC) system is provided. The method includes receiving a measurement of an output voltage of a High Voltage DC bus and receiving a measurement of a load current for each of a plurality of channels coupled to the High Voltage DC bus. The method also includes, when the output voltage is determined to be out of balance, comparing the measurement of the load current of each of the plurality of channels in the frequency domain, and, flagging one channel of the plurality of channels as a faulty channel based on the comparing the measurement of the load currents in the frequency domain.

**DRAWINGS**

Embodiments of the present invention can be more easily understood and further advantages and uses thereof more readily apparent, when considered in view of the description of the preferred embodiments and the following figures in which:

FIG. 1 is a block diagram of an embodiment of a power distribution system that provides high voltage direct current (DC) power through multiple channels with a floating ground and fault detection and isolation.

FIG. 2 is a flow chart of one embodiment of a process for identifying and isolating a fault in a power distribution system that provides high voltage DC power through multiple channels with a floating ground.

FIG. 3 is a graph that illustrates the impact of a fault on a power bus in a power distribution system that provides high voltage DC power through multiple channels with a floating ground.

FIG. 4 is a graph that illustrates the impact of a fault in the time domain on current in a channel of a power distribution system that provides high voltage DC power through multiple channels with a floating ground.

FIG. 5 is a graph that illustrates the current, in the time domain and in the frequency domain, in a non-fault condition in a channel of a power distribution system that provides high voltage DC power through multiple channels with a floating ground.

FIG. 6 is a graph that illustrate the current, in the time domain and in the frequency domain, in a fault condition in a channel of a power distribution system that provides high voltage DC power through multiple channels with a floating ground.

In accordance with common practice, the various described features are not drawn to scale but are drawn to emphasize features relevant to the present invention. Reference characters denote like elements throughout figures and text.

## DETAILED DESCRIPTION

In the following detailed description, reference is made to the accompanying drawings that form a part hereof, and in which is shown by way of specific illustrative embodiments in which the invention may be practiced. These embodiments are described in sufficient detail to enable those skilled in the art to practice the invention, and it is to be understood that other embodiments may be utilized and that logical, mechanical and electrical changes may be made without departing from the scope of the present invention. The following detailed description is, therefore, not to be taken in a limiting sense.

Embodiments of the present invention provide systems and methods for detecting faults in a channel of a multi-channel power distribution system that distributes high power direct current (DC) power over a plurality of channels with a floating ground. The fault is detected in a two-step process. First, when a fault occurs, the voltage on a power bus of the system goes out of balance. In other words, the power bus of the power distribution system has two busses: a positive bus and a negative bus. When there are no faults, the two buses are equally distributed around DC ground. But, when a fault occurs, the busses float to different levels such that the busses are not centered around DC ground. So, the first step in detecting the fault is to detect that the power busses are out of balance relative to ground.

The second step is to identify which of the channels in the multi-channel power distribution system has the fault. In a grounded system, this is easy to do because the fault causes a large current to flow in the channel or branch associated with the fault. However, one of the benefits of the floating ground is that the fault does not create a high current signal. Therefore, a different approach to detect the location of the fault had to be created. From observation, it was discovered that the branch that had the fault exhibited a high frequency component in its channel current. In a multi-channel system, the faulty channel could be detected by looking at the high frequency components of all of the channel currents. The channel with the high frequency fault current component is the channel with the fault.

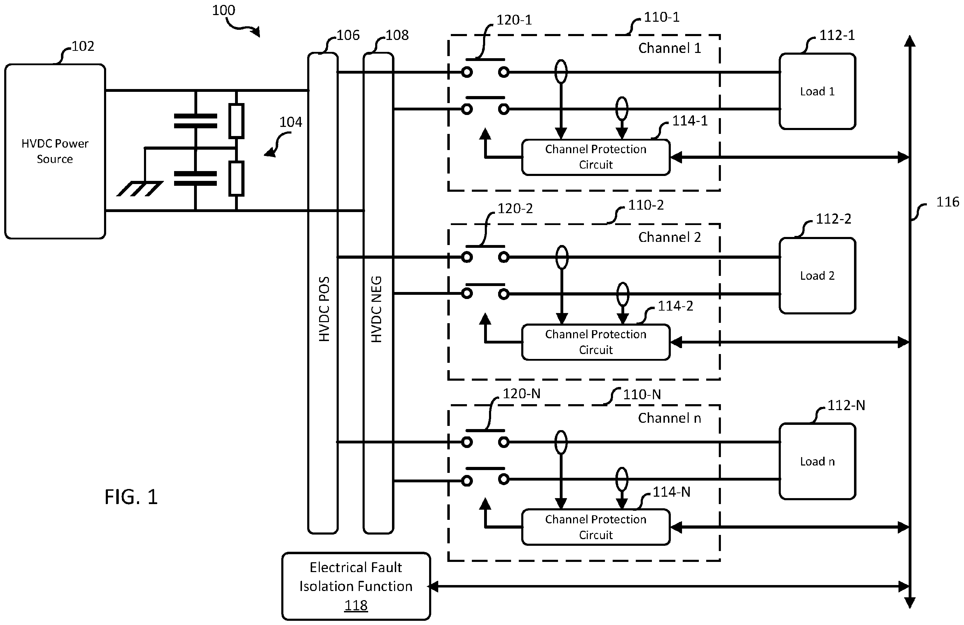

Figure 1 depicts a high voltage direct current (HVDC) electrical power generation system indicated generally at 100. System 100 includes a high voltage DC power source 102. In one embodiment, power source 102 is a power generator with rectifiers, while in other configurations, power source 102 is a battery or other appropriate source of DC power. In embodiments of the present invention, the midpoint of the power source is left open such that the system 100 has a floating ground. System 100 includes DC link capacitors and balancing resistor network 104 that are coupled to ground, e.g., the chassis ground of the system powered by system 100. The purpose of the DC Link Capacitors and balancing resistor network 104 is to ensure that the common mode voltage between aircraft structure and midpoint of the DC supply remains in control and is approximately 0 volts.

Power source 102 is coupled to high voltage DC positive bus (HVDC POS) 106 and high voltage DC negative buss (HVDC NEG) 108. From these buses, power is supplied over power distribution system that includes a plurality of branches or channels 110-1 to 110-N. Each channel 110-1 to 100-N provides power for an associated load 112-1 to 112-N, respectively. Loads 112-1 to 112-N are DC loads. However, the loads 112-1 to 112-N are so-called "switching loads" such as power inverters or DC to DC power supplies. These loads have a fundamental switching frequency such that, in the presence of a fault, the loads will produce a detectable AC current at the switching frequency of the load. This phenomenon is what produces the high frequency component in the fault current that is detectable to identify the fault condition, and more specifically, which of the plurality of channels 110-1 to 110-N that contains the fault.

Each of the channels 110-1 to 110-N includes a channel protection circuit 114-1 to 114-N. The channel protection circuit 114 measures the current in its respective channel. Advantageously, the channel protection circuits 114-1 to 114-N measure the current in their respective channels in the frequency domain. In one embodiment, the channel protection circuits 114-1 to 114-N measure the DC current of their respective channels 114-1 to 114-N and then perform a fast Fourier transform, high pass filter function and peak detector or other function to generate a measure of the channel current in the frequency domain. Additionally, the channel protection circuit 114, in some embodiments, also measures the voltage on the positive bus 106 and the negative bus 108. In other embodiments, the voltage on positive bus 106 and negative bus 108 are measured by other circuits with access to measure the voltage on the busses.

Each of the channels 110-1 to 110-N also includes a switching element 120-1 to 120-N that is configured to connect and disconnect its associated channel from receiving power from system 100. Switching elements 120-1 to 120-N are controlled by associated channel protection circuit 114-1 to 114-N, respectively. When a fault is detected on a particular channel, the channel protection circuit 114 isolates the channel 110 from system 100 by flipping the switching element 120 into a disconnected state.

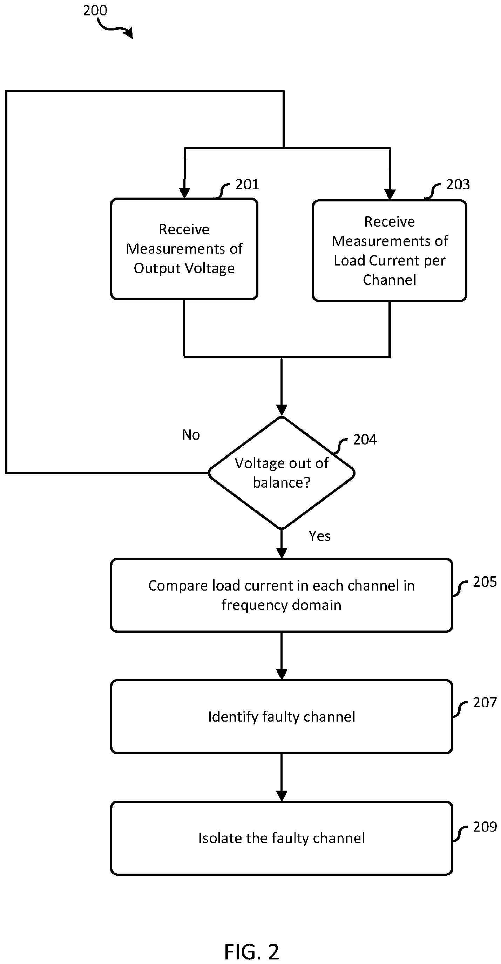

System 100 further includes electrical fault isolation function 118. Electrical fault isolation function 118 is configured to detect a fault in system 100 and to detect the channel 110 that contains the fault. Once detected, electrical fault isolation function 118 is configured to isolate the channel 110 with the faulty circuit from the rest of system 100 using the channel protection circuit 114 and the switching element 120 of the channel identified with the fault. One embodiment of the process implemented by electrical fault isolation function 118 is shown and described by way of example with respect to Figure 2 below.

In one embodiment, electrical fault isolation function 118 is implemented using a processor that runs instructions The methods and techniques described here may be implemented in digital electronic circuitry, or with a programmable processor (for example, a special-purpose processor or a general-purpose processor such as a computer) firmware, software, or in combinations of them. Apparatus embodying these techniques may include appropriate input and output devices, a programmable processor, and a storage medium tangibly embodying program instructions for execution by the programmable processor. A process embodying these techniques may be performed by a programmable processor executing a program of instructions to perform desired functions by operating on input data and generating appropriate output. The techniques may advantageously be implemented in one or more programs that are executable on a programmable system including at least one programmable processor coupled to receive data and instructions from, and to transmit data and instructions to, a data storage system, at least one input device, and at least one output device. Generally, a processor will receive instructions and data from a read-only memory and/or a random access memory or other non-transitory computer readable medium. Storage devices suitable for tangibly embodying computer program instructions and data include all forms of non-volatile memory, including by way of example semiconductor memory devices, such as EPROM, EEPROM, and flash memory devices; magnetic disks such as internal hard disks and removable disks; magneto-optical disks; and DVD disks. Any of the foregoing may be supplemented by, or incorporated in, specially designed application-specific integrated circuits (ASICs) or Field Programmable Gate Arrays (FGPAs).

System 100 also includes a communication bus 116 that is configured to communicate information between components of system 100. For example, channel protection circuit 114 is coupled to a communication bus 116. Further, electrical fault isolation function 118 is also coupled to communication bus 116. In one embodiment, electrical isolation function 118 receives the data it needs to detect a fault condition in one of the channels 110 of system 100. For example, channel protection circuit 114 provides current measurements for its associated channel to electrical fault isolation function over communication bus 116. Additionally, in some embodiments, channel protection circuit 114 also provides measured voltages for the voltages on the positive bus 106 and the negative bus 108 to electrical fault isolation function 118. In other embodiments, the voltage of the positive bus 106 and the voltage of the negative bus 108 are provided from other circuits associated with system 100.

In operation, electrical fault isolation function 118 detects a fault in system 100 in a two-step process. First, electrical fault isolation function 118 monitors the voltage on positive bus 106 and negative bus 108 to determine when the voltage on the bus is out of balance. As a result, the bus voltages have moved from being centered around DC ground by more than a threshold value. When the voltage on the bus is determined to be out of balance, electrical fault isolation function 118 determines that a fault condition exists. Next, electrical fault isolation function 118 compares the current in each of the channels 110-1 to 110-N in the frequency domain. Electrical fault isolation function 118 determines the channel with the fault condition by identifying or flagging the channel 110 with the high frequency current signal with the highest magnitude. Once flagged, electrical fault isolation function 118 is configured to further isolated the channel 110 with the faulty circuit by communicating with the associated channel protection circuit 114. The channel protection circuit 114 then isolates the associated channel from system 100 through switching element 120.

Figure 2 is a flow chart of one embodiment of a process, indicated generally at 200, for detecting and isolating a fault in a power distribution system that provides high voltage DC power through multiple channels with a floating ground to an electrical system such as an aircraft, ground vehicle or water craft. In one embodiment, process 200 is used by electrical fault isolation function 118 of system 100 of Figure 1 to detect and isolate faults in system 100. It is understood that process 200 can be implemented to detect and isolate faults in other systems with floating grounds. The description of process 200 in conjunction with system 100 of Figure 1 is provided by way of example and not by way of limitation.

Process 200 begins at blocks 201 and 203. At block 201, the output voltage on the high voltage power bus is received, e.g., the voltage of positive bus 106 and the voltage on negative bus 108. In the example of system 100, the voltage of the high voltage power bus is received by electrical fault isolation function 118 from channel protection circuits 114-1 to 114-N or some other source of the voltage measurement. The voltage provided to process 200 is a measurement of the voltage on the positive bus relative to a ground voltage of the electrical system (system ground or chassis ground) ($V_{POS}$ - Chassis GND) and a measurement of the voltage on the negative bus relative to system or chassis ground (Chassis GND - $V_{NEG}$). Additionally, at block 203, process 200 receives the load current for each channel of the power distribution system. For example, in the example of Figure 1, electrical fault isolation function 118 receives the load current for each of the channels 110-1 to 110-N via communication bus 116 and channel protection circuits 114-1o 114-N, respectively. In one embodiment, this load current is a measurement of the current in the frequency domain by the channel protection circuits 114-1 to 114-N such as by performing an FFT, high pass filter and peak detector or other function that provides a frequency domain signal to electrical fault isolation function 118.

With the voltage and current information, process 200 has the data necessary to detect a fault in any of the channels of the power distribution system. In the system of Figure 1, electrical fault isolation function 118 determines if there is a fault in any of the channels 110-1 to 110-N.

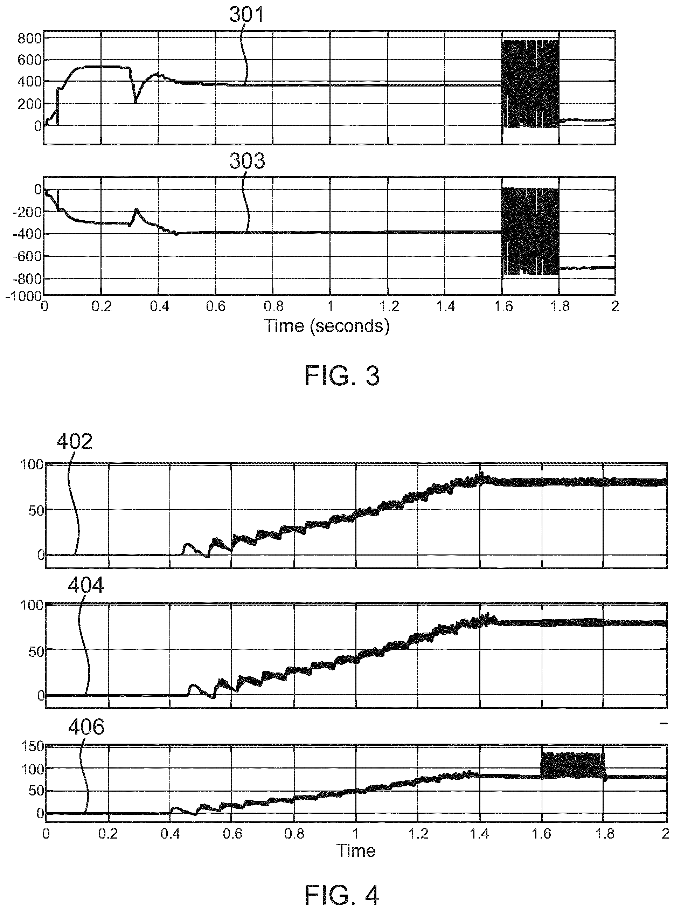

First, process 200 determines, at block 204, if there is an imbalance in the voltage on the high voltage power bus using the data received in blocks 201. As a reminder, when the floating system operates in a normal condition (no fault), the voltages on the positive and negative buses are centered roughly around DC ground. Figure 3 illustrates this in curves 301 and 303. Curve 301 illustrates an example of a voltage on a positive bus and curve 303 illustrates an example of a voltage on a negative bus. Prior to 1.6 seconds, curves 301 and 303 are centered around DC ground with curve 301 at approximately 400 Volts and curve 303 at approximately -400 volts. If a fault occurs, then this balance is disturbed and the voltage differential between the buses moves up or down relative to DC ground. This movement is detected at block 204. For example, in the system of Figure 1, electrical fault isolation function 118 determines if the voltage on the positive bus ($V_{POS}$) 106 and the voltage on the negative bus ($V_{NEG}$) 108 are out of balance according to the following equation:

$$(1) \quad (V_{POS} - \text{Chassis GND}) - (\text{Chassis GND} - V_{NEG}) > \text{Voltage Imbalance Threshold}$$

If the voltage is not out of balance, process 200 returns to block 201 and continues to receive data on the voltage on the high voltage power bus, e.g., positive bus 106 and negative bus 108 and the currents in the channels, e.g., channels 110-1 to 110-N of system 100, on a continuous basis.

If, however, process 200 determines that the voltage on the high voltage bus is out of balance, then a fault has been detected. This is illustrated in Figure 3 where a fault occurs between 1.6 and 1.8 seconds. After the fault occurs, the voltage on the positive bus drops to just above 0 Volts and the voltage on the negative bus decreases to about -800 Volts. Thus, the voltage on the high voltage bus is now centered around -400 Volts.

Next, process 200 determines which of channels contains the fault (e.g., a wire fault). Unlike in a grounded system, there is no spike in the DC current in the faulty one of the channels. This is illustrated in Figure 4 which includes graphs that illustrates the impact of a fault in the time domain on current in a channel of a power distribution system that provides high voltage DC power through multiple channels with a floating ground. In this example, curves 402, 404 and 406 illustrate measurements of currents in three channels of a power distribution system. Curves 402 and 404 illustrate current measurements for channels without a fault. Curve 406 illustrates current for a channel with a fault condition that occurs between 1.6 and 1.8 seconds. As can be seen, after 1.8 seconds, there is no appreciable different between the readings in the various channels in the time domain. Specifically, there is no high current reading that would be anticipated in a channel of a grounded, power distribution system that experienced a fault.

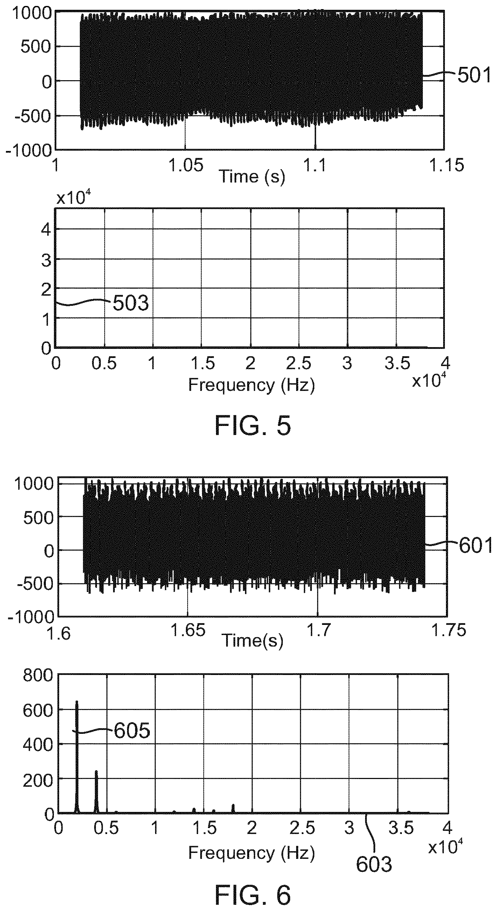

Therefore, process 200 cannot simply look for a high DC current in one of the channels. However, it has been determined that a fault in a power distribution system with a floating ground can be detected by looking at the current in each branch of the distribution system in the frequency domain because, in a power distribution system with a floating ground, there is a new frequency component in the DC bus current when a fault condition exists. Figure 5 shows a current reading in the time domain (501) and the frequency domain (502) for a channel without a fault. In this case, the frequency domain does not show any high frequency component to the current signal. In contrast, Figure 6 shows a current reading in the time domain (601) and the frequency domain (603) for a channel that has experienced a fault condition. It is indicated at 605, for example, that the frequency domain of this current signal shows high frequency current components that differ from frequency domain signal (503) of a channel without a fault. By analyzing the DC current of each channel of the power distribution system in the frequency domain, it is possible to detect the channel of the power distribution system that contains this new (high) frequency current component and thus the location of the fault. Therefore, process 200 compares the currents in each of the channels in the frequency domain at block 205. In the example of Figure 1, electrical fault isolation function 118 compares the currents in channels 110-1 to 110-N in the frequency domain, using a fast Fourier transform, high pass filter and peak detector or other function that enables a view of the frequency domain of the current measurements. At block 207, process 200 further identifies the faulty channel based on the comparison of the currents in the frequency domain. In the example of Figure 1, electrical fault isolation function 118 selects the channel with the high frequency content in the current measurement with the highest magnitude as the channel with the fault.

Once identified, process 200 takes corrective action at block 209 by isolating the faulty channel from the high voltage bus of the system. In the embodiment of Figure 1, this entails electrical fault isolation function 118 sending a message to the channel protection circuit 114 associated with the faulty channel 110 to activate switching element 120 to disconnect the channel 110 from the positive bus 106 and negative bus 108.

## EXAMPLE EMBODIMENTS

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the present invention. Therefore, it is manifestly intended that this invention be limited only by the claims and the equivalents thereof.

Example 1 includes a method for isolating an electrical fault in a floating High Voltage direct current (DC) system, the method comprising: receiving a measurement of an output voltage of a High Voltage DC bus; receiving a measurement of a load current for each of a plurality of channels coupled to the High Voltage DC bus; when the output voltage is determined to be out of balance, comparing the measurement of the load current of each of the plurality of channels in the frequency domain; and flagging one channel of the plurality of channels as a faulty channel based on the comparing the measurement of the load currents in the frequency domain.

Example 2 include the method of Example 1, wherein receiving the measurement of the output voltage comprises: receiving a measurement of a first voltage of a positive bus; and receiving a measurement of a second voltage of a negative bus.

Example 3 includes the method of Example 2, and further comprising isolating the faulty channel from the positive bus and the negative bus.

Example 4 includes the method of any of Examples 2 and 3, wherein receiving a measurement of the output voltage comprises: receiving a measurement of the first voltage of the positive bus relative to a chassis ground; receiving a measurement of the second voltage of the negative bus relative to the chassis ground; determining a difference between the first voltage and the second voltage; and when the difference exceeds a threshold, declaring that the output voltage is out of balance.

Example 5 includes the method of any of Examples 1 to 4, wherein receiving the measurement of the load current for each of the plurality of channels comprises receiving the measurement derived by performing a high pass filter function with peak detection on a signal representing the load current for each of the plurality of channels.

Example 6 includes the method of any of Examples 1 to 4, wherein receiving the measurement of the load current for each of the plurality of channels comprises receiving the measurement derived by performing a fast Fourier transform on the measurement of the load current for each of the plurality of channels.

Example 7 includes the method of any of Examples 1 to 6, wherein comparing the load current of each of the plurality of channels in the frequency domain comprises identifying a channel in the plurality of channels that has a high frequency load current with the highest magnitude.

Example 8 includes the method of any of Examples 1 to 7, wherein comparing the load current of each of the plurality of channels in the frequency domain comprises identifying a signal at a fundamental switching frequency of a DC load associated with one of the plurality of channels.

Example 9 includes a high voltage direct current (DC) power system, comprising: a high voltage power source; a high voltage positive bus coupled to the high voltage power source; a high voltage negative bus coupled to the high voltage power source; a common mode capacitor circuit, coupled to the high voltage positive bus, the high voltage negative bus, and the high voltage power source such that the high voltage positive bus and the high voltage negative bus have a floating ground; a plurality of power distribution channels, each of the plurality of power distribution channels is coupled to the high voltage positive bus and the high voltage negative bus, and configured to be coupled to a load; wherein each of the plurality of power distribution channels comprises a channel protection circuit that is configured to measure a current in an associated power distribution channel; and an electrical fault isolation function, coupled to the channel protection circuit of each of the plurality of power distribution channels, wherein the electrical fault isolation function receives current measurements from the channel protection circuit of each of the plurality of power distribution channels and identifies and isolates a faulty one of the plurality of power distribution channels based on an imbalance in a first voltage on the high voltage positive bus and a second voltage on the high voltage negative bus and based on comparing the current measurements from the channel protection circuit of each of the plurality of power distribution channels in the frequency domain.

Example 10 includes the high voltage DC power system of Example 9, wherein each load coupled to the plurality of power distribution channels is a load with a fundamental switching frequency.

Example 11 includes the high voltage DC power system of Example 10, wherein each load coupled to the plurality of power distribution channels is a power inverter or a DC/DC power supply.

Example 12 includes the high voltage DC power system of any of Examples 9 to 11, wherein the channel protection circuit of each of the plurality of power distribution channels is further configured to measure voltage on the high voltage positive bus and the high voltage negative bus and to provide the measured voltages to the electrical fault isolation function.

Example 13 includes the high voltage DC power system of any of Examples 9 to 12, wherein the channel protection circuit of each of the plurality of power distribution channels is configured to receive a signal from the electrical fault isolation function to isolate the faulty one of the plurality of power distribution channels.

Example 14 includes the high voltage DC power system of any of Examples 9 to 13, wherein the channel protection circuit of each of the plurality of power distribution channels uses a fast Fourier transform or a high pass filter function and a peak detector to create the current measurements of high frequency current components.

Example 15 includes the high voltage DC power system of any of Examples 9 to 14, wherein the electrical fault isolation function compares the current measurements in the frequency domain to identify a power distribution channel of the plurality of power distribution channels with a highest high frequency current.

Example 16 includes a high voltage direct current (DC) distribution system, comprising: an high voltage bus including a high voltage positive bus and a high voltage negative bus, wherein the high voltage bus has a floating ground; a plurality of power distribution channels, each of the plurality of power distribution channels is coupled to the high voltage bus, and configured to be coupled to a load; and an electrical fault isolation function, configured to receive voltage measurements for the high voltage bus and current measurements for each of the plurality of power distribution channels, wherein the electrical fault isolation function is configured to identify and isolate a faulty one of the plurality of power distribution channels based on an imbalance in the voltage measurements for the high voltage bus and based on a comparison of the current measurements for each of the plurality of power distribution channels in the frequency domain.

Example 17 includes the high voltage DC distribution system of Example 16, wherein each of the plurality of power distribution channels includes a channel protection circuit that is configured to measure a current in an associated one of the plurality of power distribution channels.

Example 18 includes the high voltage DC distribution system of Example 17, wherein the channel protection circuit of each of the plurality of power distribution channels also is configured to measure a first voltage of the high voltage positive bus and a second voltage of the high voltage negative bus.

Example 19 includes the high voltage DC distribution system of any of Examples 17 and 18, wherein the channel protection circuit of each of the plurality of power distribution channels is configured to receive a signal from the electrical fault isolation function to isolate the faulty one of the plurality of power distribution channels.

Example 20 includes the high voltage DC distribution system of any of Examples 16 to 19, wherein the channel protection circuit of each of the plurality of power distribution channels uses a fast Fourier transform or a high pass filter function with peak detection to create the current measurements in the frequency domain, and wherein the electrical fault isolation function compares the current measurements in the frequency domain to identify a power distribution channel of the plurality of power distribution channels with a highest high frequency current.

**Claims**

1. A method for isolating an electrical fault in a floating High Voltage direct current (DC) system, the method comprising:

   receiving a measurement of an output voltage of a High Voltage DC bus;
   receiving a measurement of a load current for each of a plurality of channels coupled to the High Voltage DC bus;
   when the output voltage is determined to be out of balance, comparing the measurement of the load current of each of the plurality of channels in the frequency domain; and
   flagging one channel of the plurality of channels as a faulty channel based on the comparing the measurement of the load currents in the frequency domain.

2. The method of claim 1, wherein receiving the measurement of the output voltage comprises:

   receiving a measurement of a first voltage of a positive bus; and
   receiving a measurement of a second voltage of a negative bus.

3. The method of claim 2, and further comprising isolating the faulty channel from the positive bus and the negative bus.

4. The method of claim 2, wherein receiving a measurement of the output voltage comprises:

receiving a measurement of the first voltage of the positive bus relative to a chassis ground;
receiving a measurement of the second voltage of the negative bus relative to the chassis ground;
determining a difference between the first voltage and the second voltage; and
when the difference exceeds a threshold, declaring that the output voltage is out of balance.

5. The method of claim 1, wherein receiving the measurement of the load current for each of the plurality of channels comprises receiving the measurement derived by performing a high pass filter function with peak detection on a signal representing the load current for each of the plurality of channels, or receiving the measurement derived by performing a fast Fourier transform on the measurement of the load current for each of the plurality of channels.

6. The method of claim 1, wherein comparing the load current of each of the plurality of channels in the frequency domain comprises identifying a channel in the plurality of channels that has a high frequency load current with the highest magnitude.

7. A high voltage direct current (DC) distribution system, comprising:

an high voltage bus including a high voltage positive bus and a high voltage negative bus, wherein the high voltage bus has a floating ground;
a plurality of power distribution channels, each of the plurality of power distribution channels is coupled to the high voltage bus, and configured to be coupled to a load; and
an electrical fault isolation function, configured to receive voltage measurements for the high voltage bus and current measurements for each of the plurality of power distribution channels, wherein the electrical fault isolation function is configured to identify and isolate a faulty one of the plurality of power distribution channels based on an imbalance in the voltage measurements for the high voltage bus and based on a comparison of the current measurements for each of the plurality of power distribution channels in the frequency domain.

8. The high voltage DC distribution system of claim 7, wherein each of the plurality of power distribution channels includes a channel protection circuit that is configured to measure a current in an associated one of the plurality of power distribution channels.

9. The high voltage DC distribution system of claim 8, wherein the channel protection circuit of each of the plurality of power distribution channels is configured to receive a signal from the electrical fault isolation function to isolate the faulty one of the plurality of power distribution channels.

10. The high voltage DC distribution system of claim 7, wherein the channel protection circuit of each of the plurality of power distribution channels uses a fast Fourier transform or a high pass filter function with peak detection to create the current measurements in the frequency domain, and wherein the electrical fault isolation function compares the current measurements in the frequency domain to identify a power distribution channel of the plurality of power distribution channels with a highest high frequency current.

FIG. 1

EP 4 293 848 A1

200

201 — Receive Measurements of Output Voltage

203 — Receive Measurements of Load Current per Channel

204 — Voltage out of balance?

No

Yes

205 — Compare load current in each channel in frequency domain

207 — Identify faulty channel

209 — Isolate the faulty channel

FIG. 2

FIG. 3

FIG. 4

FIG. 5

FIG. 6

Europäisches
Patentamt
European
Patent Office
Office européen
des brevets

# EUROPEAN SEARCH REPORT

Application Number

EP 23 17 6302

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/056896 A1 (BEIJING ETECHWIN ELECTRIC CO LTD [CN]) 1 April 2021 (2021-04-01) | 1-3,5-10 | INV. H02H3/28 H02H7/26 |
| Y | * pages 4,5; figures 1, 3,4,5A,7 * | 4 | H02H3/52 |
| Y | US 2009/085574 A1 (PAN YAN [US] ET AL) 2 April 2009 (2009-04-02) * paragraphs [0045] – [0051]; figures 3,4 * | 4 | |
| X,P | CN 114 865 601 A (QINGDAO POWER SUPPLY CO STATE GRID SHANDONG ELECTRIC POWER CO ET AL.) 5 August 2022 (2022-08-05) * Embodiment 2; figure 1 * | 1-10 | |
| | | | TECHNICAL FIELDS SEARCHED (IPC) |
| | | | H02H G01R |

The present search report has been drawn up for all claims

| Place of search | Date of completion of the search | Examiner |
|---|---|---|
| Munich | 11 November 2023 | Colombo, Alessandro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 6302

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2023

| Patent document cited in search report | Publication date | Patent family member(s) | Publication date |
|---|---|---|---|
| WO 2021056896 A1 | 01-04-2021 | CN 112582992 A<br>WO 2021056896 A1 | 30-03-2021<br>01-04-2021 |
| US 2009085574 A1 | 02-04-2009 | NONE | |
| CN 114865601 A | 05-08-2022 | NONE | |

EPO FORM P0459

For more details about this annex : see Official Journal of the European Patent Office, No. 12/82